(19) **Europäisches Patentamt**

**European Patent Office**

**Office européen des brevets**

(11) **EP 0 639 891 B1**

(12) **EUROPEAN PATENT SPECIFICATION**

(45) Date of publication and mention
of the grant of the patent:
**11.11.1998 Bulletin 1998/46**

(51) Int Cl.6: **H03H 17/06**, H03H 17/02,
H04N 9/78

(21) Application number: **94203121.2**

(22) Date of filing: **07.03.1991**

(54) **Logical comb filters**

Logische Kammfilter

Filtres logiques en peigne

(84) Designated Contracting States:
**DE FR GB**

(30) Priority: **08.03.1990 JP 57382/90**

(43) Date of publication of application:
**22.02.1995 Bulletin 1995/08**

(62) Document number(s) of the earlier application(s) in
accordance with Art. 76 EPC:
**91301910.5 / 0 446 053**

(73) Proprietor: **SONY CORPORATION**
**Tokyo (JP)**

(72) Inventor: **Senuma, Toshitaka,**
**Intell. Property Division**
**Shinagawa-ku, Tokyo 141 (JP)**

(74) Representative: **Cotter, Ivan John et al**
**D. YOUNG & CO.**
**21 New Fetter Lane**
**London EC4A 1DA (GB)**

(56) References cited:
**EP-A- 0 322 890**          **US-A- 4 809 060**

- **FERNSEH UND KINOTECHNIK, vol.44, no.2,
February 1990, BERLIN DE pages 80 - 81 'Neuere
Entwicklungen bei Betacam.'**
- **PATENT ABSTRACTS OF JAPAN vol. 14, no. 102
(E-894) 23 February 1990 & JP-A-01 303 891 (NEC
HOME ELECTRON) 7 December 1989**

**Description**

This invention relates to logical comb filters . Such filters may, for example, be used in video apparatus to separate a luminance signal (Y) from a chrominance signal (C).

In separating vertically a luminance signal (Y) from a chrominance signal (C) in video apparatus, a logical comb filter employs logic circuits to carry out comparisons of three line signals, corresponding to previous, present and next lines, so as to minimise signal irregularities (dot disturbance, discolouring, etc.) resulting from the use of the signals with low vertical correlation.

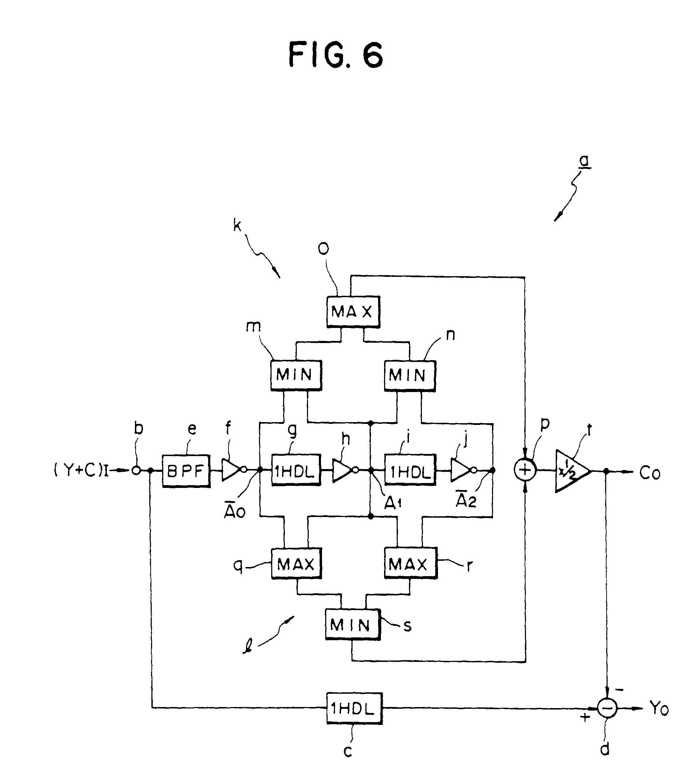

Figure 6 shows a typical logical comb filter a of the NTSC standard comprising an input terminal b through which a composite signal $(Y+C)_l$ is input. The input signal $(Y+C)_l$ is supplied via a 1H delay line c to a subtracter d, and also to a band-pass filter e whose centre frequency is $f_{sc}$ (the colour sub-carrier frequency).

The signal in the vicinity of $f_{sc}$, when extracted by the band-pass filter e is supplied to a 1H delay line g via a NOT circuit f which supplies an output signal $\overline{A}_0$, the bar meaning inversion of phase. The signal on the 1H delay line g is then supplied to a NOT circuit h that generates a signal $A_1$ delayed by 1H relative to the signal $\overline{A}_0$.

In addition, a 1H delay line i and a NOT circuit j downstream thereof derive a signal $\overline{A}_2$ delayed by 1H relative to the signal $A_1$.

The three line signals $\overline{A}_0$, $A_1$ and $\overline{A}_2$, obtained with the 1H time spacing therebetween, are processed by logic operation units k and l which comprise MAX and MIN circuits, the MAX circuits extracting the signals whose levels are the highest, and the MIN circuits extracting the signals whose levels are the lowest.

Specifically, in the logic operation unit k, the signals $\overline{A}_0$ and $A_1$ are supplied to a MIN circuit m, and the signals $A_1$ and $\overline{A}_2$ are supplied to a MIN circuit n. The outputs from the MIN circuits m and n are supplied to a MAX circuit o whose output is in turn supplied to an adder p.

In the logic operation unit l, the signals $\overline{A}_0$ and $A_1$ are supplied to a MAX circuit q and the signals $A_1$ and $\overline{A}_2$ are supplied to a MAX circuit r. The outputs from the MAX circuits q and r are supplied to a MIN circuit s whose output in turn is supplied to the adder p.

The output from the adder p is output as a C (chrominance) signal $C_0$ via a multiplier t having a coefficient of 1/2. The adder output is also supplied to the subtracter d wherein the signal $C_0$ is subtracted from the 1H delayed signal of the input signal $(Y+C)_l$ to provide a luminance signal $Y_0$.

In the above-described logical comb filter a, the three line signals $\overline{A}_0$, $A_1$ and $\overline{A}_2$ are processed according to the following two algorithms:

(1) If the level of the signal $A_1$ is between those of the signals $\overline{A}_0$ and $\overline{A}_2$, the signal $A_1$ is adopted as the signal $C_0$.
It is assumed that $V_0$, $V_1$ and $V_2$ designate the levels of the signals $\overline{A}_0$, $A_1$ and $\overline{A}_2$, respectively. If $V_0 < V_1 < V_2$ or if $V_0 > V_1 > V_2$, then the intermediate level signal $A_1$ is supplied as the signal $C_0$.

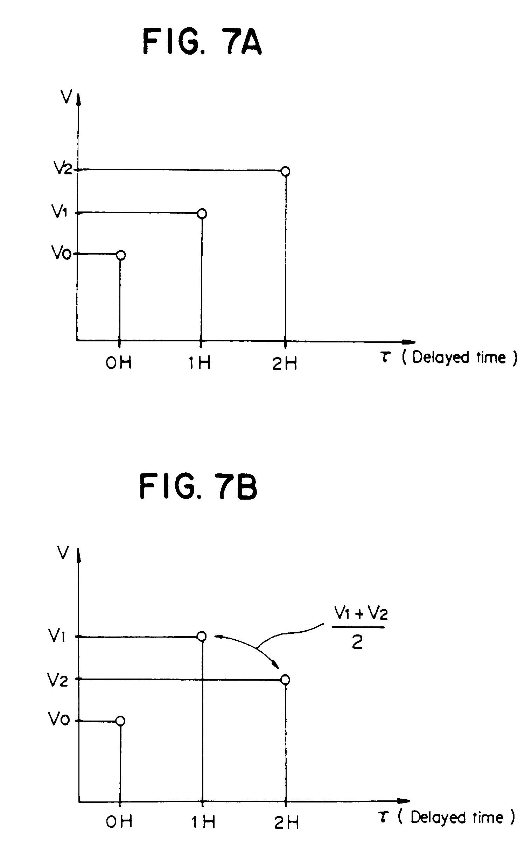

For example, the case where $V_0 < V_1 < V_2$, as illustrated in Figure 7A, is considered. In Figure 7, the horizontal axes stands for delay times $\tau$ and the vertical axes for signal levels V. The levels $V_0$, $V_1$ and $V_2$ are indicated by hollow circles.

In the logic operation unit k, the MAX circuit o selects the signal $A_1$, which has the higher signal level and is obtained by the MIN circuit n, in preference to the signal $\overline{A}_0$ acquired by the MIN circuit m; the selected signal $A_1$ is supplied to the adder p. In the logic operation unit l, the MIN circuit s selects the signal $A_1$, which has the lower signal level and is obtained by the MAX circuit q, in preference to the signal $\overline{A}_2$ acquired by the MAX circuit r; the selected signal $A_1$ is supplied to the adder p. It follows that the mean output level obtained by the adder p and the multiplier t is $V_1$, which is exactly the same as in the case where the signal $A_1$ is adopted.

The other algorithm is:

(2) If the level of the signal $A_1$ is not between those of the signals $\overline{A}_0$ and $\overline{A}_2$, the mean level between the signal $A_1$ and the signal whose signal level is the closer to that of the former is adopted as the output level of the signal $C_0$.

That is, if $V_1 > V_2$ or $V_1 < V_0$ where $V_0 < V_2$ or, conversely, if $V_1 < V_2$ or $V_1 > V_0$ where $V_0 > V_2$, a comparison is made between $|V_1 - V_0|$ and $|V_1 - V_2|$. What is adopted here is the mean level between $V_1$ and the signal level ($V_0$ or $V_2$) which is the lower of the two.

For example, in the logic operation unit k and where $V_0 < V_2 < V_1$, as depicted in Figure 7B, the MAX circuit o selects the signal $\overline{A}_2$, which is obtained by the MIN circuit n and has the higher signal level, in preference to the signal $\overline{A}_0$ acquired by the MIN circuit m; the selected signal $\overline{A}_2$ is supplied to the adder p. In the logic operation unit l, the MAX circuits q and r both yield the signal $A_1$; the signal $A_1$ is then sent from the MIN circuit s to the adder p. What is adopted here is a signal with a level $(V_1 + V_2)/2$ , the signal being acquired by the adder p and the subtracter t. That is, the mean output between the level $V_1$ and the level $V_2$ which is the closer of the remaining two to the former is used as the signal $C_0$.

In the above-described logical comb filter a, the two kinds of signal processing are carried out as described centring on the signal $A_1$: (1) where vertical correlation between the three line signals is high, or (2) where the vertical correlation between the three line signals is low.

One disadvantage of the above logical comb filter a is that the logic operation units k and l comprise a large number of component devices. Another disadvantage is that it is difficult to modify the circuit configuration thereof.

That is, the many comparators used in the MIN and MAX circuits constituting the logic operation units k and l boost the number of gates, which pushes up the cost.

The reason that the circuit configuration is difficult to modify is that the decision on signal selection is not separated from the actual selection of signals in the logic operation units k and l (in fact, the two kinds of processing are mixed therein).

In the logical comb filter a, any modification of or addition to the algorithms used requires major revisions in the configuration of the logic operation units. In that case, it is difficult to foresee how the eventual circuit configuration will turn out, because the existing arrangements hardly provide adequate guidelines to the modification or addition required.

For example, with the algorithms (1) and (2) described above, the Y/C separation is neatly carried out at a vertical edge involving transition from the portion with the chrominance signal to the portion without it. By contrast, where a vertical stripe pattern v of the Y signal having the $F_{sc}$ component appears on a monitor screen u, irregularities occur at edges w and w'.

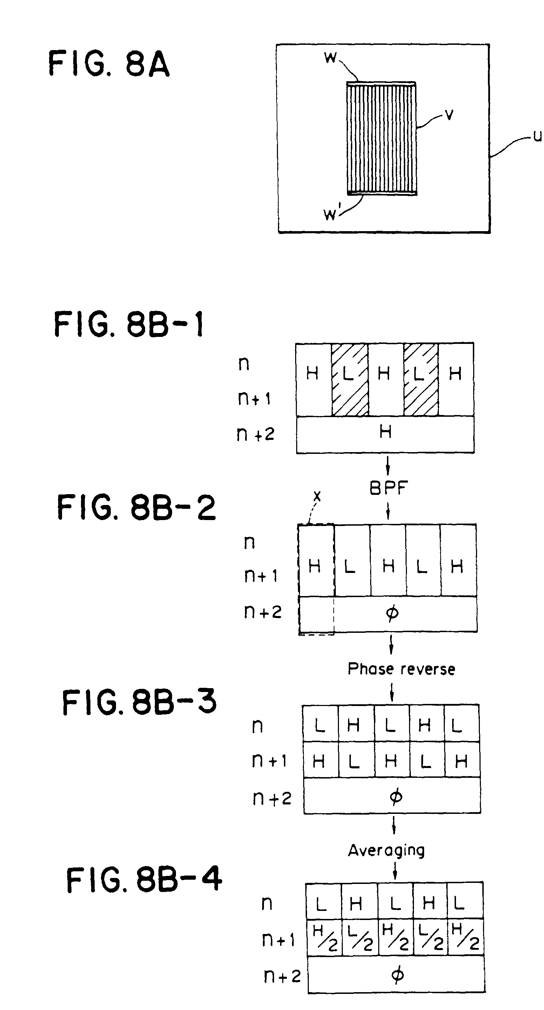

Figure 8B shows the above situation. With respect to the lower edge w' of the stripe pattern v, three lines, that is, the nth, (n+1)th and (n+2)th, are extracted and partially illustrated.

Figure 8B-1 shows how the luminance of the edge w appears on the screen. In the figure, H stands for a bright portion and L for a dark portion.

Figure 8B-2 depicts the situation in effect after signal passage through the band-pass filter e. Only those signals with large changes in luminance (that is, at high frequencies) pass the filter on the nth and (n+1)th scanning lines. The signal passage is blocked on the (n+2)th scanning line (as indicated by symbol "Ø").

Figure 8B-3 illustrates the situation in effect after the phase is reversed. With the signal of the (n+1)th line taken as the centre, the phase of that signal is opposite to that of the signal of the line on the nth line.

Figure 8B-4 shows the situation in effect after processing is carried out by the logical comb filter a according to the above-described algorithm (2). In Figure 8B-4, H/2 and L/2 mean that the luminance levels are about half that of the H portion and half that of the L portion, respectively.

That is, in Figure 8B-3, the signal of the (n+1)th line is judged to be closer to the (n+2)th line signal than to the nth line signal whose phase is inverted by the algorithm (2).

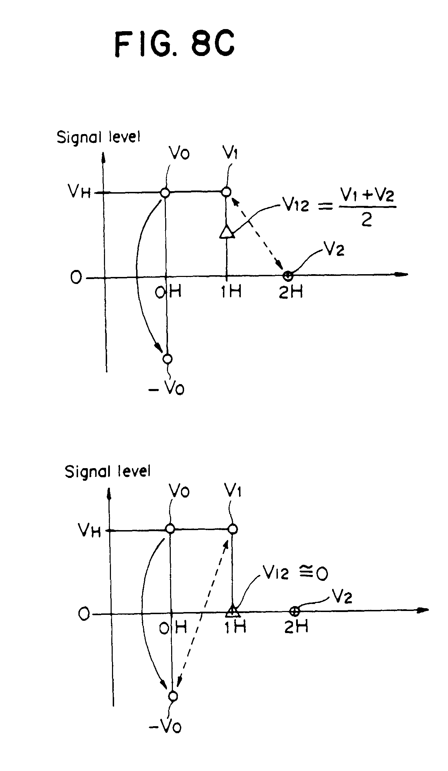

For example, regarding the portion x enclosed by broken lines in Figure 8B-2, the signal level $V_0$ of the nth line and the signal level $V_1$ of the (n+1)th line are about $V_H$ after passage through the band-pass filter e, as depicted in the upper graphic representation of Figure 8C. The signal level $V_2$ of the (n+2)th line is close to zero.

The output of the band-pass filter e is reversed in phase every time the output is delayed by 1H by the NOT circuit f downstream of the filter, or by the NOT circuits h and j downstream of the 1H delay lines g and i. Thus the signal level of the nth line is $-V_0$ (the signal level $V_2$ remains at approximately zero after phase inversion wherein $V_2 \fallingdotseq 0$).

In this manner, the signal level $V_1$ is judged to be the closest to the signal level $V_2$ according to the algorithm (2). The mean value $V_{12}$ ($= (V_1 + V_2)/2 \cong V_1/2$) is adopted as the $C_0$ signal.

Where the algorithm (2) is to be followed, the mean value is obtained between $V_1$ and the signal level close thereto. This means that the emphasis is on the processing of the chrominance signal regarding the $f_{sc}$ component of the signal. Thus the $f_{sc}$ component of the Y signal is adopted as the C signal and processed as such.

This disadvantage is avoided by the following measure: where the levels of the three line signals are in a specific relation with one another, these levels may be judged to be the $f_{sc}$ component of the Y signal, and may be suppressed from being output as the signal $C_0$. For example, the average may be obtained between the two furthest signal levels.

In the example above, as shown in the lower graphic representation of Figure 8C, the signal levels $V_1$ and $-V_0$ are averaged, the latter being the furthest from the former, that is, $V_{12} = (-V_0 + V_1)/2 \cong 0$. In that case, the mean level is not regarded as the chrominance signal. Instead, the level $V_H$ is extracted unmodified as the level of the signal $Y_0$.

What has been considered above has focused on the bright portion x. The same applies to the transition from the dark portion next to the bright portion x to the next adjacent bright portion (the only difference is in signal levels).

Where the level relationship between the three line signals is judged to be the $f_{sc}$ component of the Y signal as described, a new algorithm (3) is adopted. The algorithm (3) is stipulated as follows:

If there is a need to regard the level of the signal $A_1$ as the Y signal even although the signal level does not fall between the levels of the signals $A_0$ and $A_2$, the mean level between $V_1$ and the signal level furthest therefrom is adopted as the output level of the signal $C_0$.

The trouble is that when it comes to practising the algorithm (3) above, it has been difficult even to envisage the kind of improvement that would be needed for the construction of the logic operation units k and l.

The Patent Abstracts of Japan abstract of patent application JP-A-01-303891 shows a logical comb filter comprising a first delay line, a second delay line connected to the first delay line serially, a circuit for producing first processed signal which is one half of the first delayed signal less one quarter of the input signal and less one quarter of the second delayed signal, a circuit for producing a second processed signal based on the first delayed signal, a changeover means which receives the first and second processed signals and a correlation detection circuit connected to the input signal and the second delayed signal.

An article in Fernseh-und Kino-Technik 44(1990), No 2, Pages 80-81, "Neuere Entwicklungen bei Betacam" shows a logical comb filter for video signals, the filter comprising:

a first delay line;
a second delay line connected to said first delay line serially;
a first mean level calculator connected to an input and an output terminal of said first delay line;
a second mean level calculator connected to an input and an output terminal of said second delay line;
a changeover means connected to the output terminals of said first and
second mean level calculators; and
a control logic unit connected to the input and output terminals of said first and second delay lines.

In this filter, the changeover means is also connected to the output of a circuit which combines the signals from the outputs of the first and second mean level calculators. A document EP 322,890 discloses a logical comb filter having two delay lines with a band-pass filter interposed therebetween, switchably selectable outputs of the band-pass filter and mean signal calculators, and a control logic unit including sign detectors for selecting one of said outputs as colour signal output of the filter.

The invention is defined by the appended claims.

The filter of the present invention is characterised with respect to the last-mentioned filter in that:

the changeover means is also connected to an output of said first delay line; and
said control logic unit includes:
sign detectors connected to the input and output terminals of said delay lines; and
near-zero detectors connected to said delay lines.

The invention will now be described by way of example with reference to the accompanying drawings, throughout which like parts are referred to by like references, and in which:

Figure 1 is a circuit block diagram of an embodiment of an logical comb filter for video signals, according to the present invention;

Figure 2 is a circuit block diagram showing parts of the embodiment;

Figure 3 is a view illustrating the level relationship of the $f_{sc}$ component of the chrominance and luminance signals where the vertical correlation involved is high in a special control logic unit of the embodiment;

Figures 4A to 4D are views describing special cases where exceptional processing is carried out by the special control logic unit in the embodiment;

Figure 5 is an equivalent circuit diagram of parts of the special control logic unit in the embodiment;

Figure 6 is a circuit block diagram of a previously proposed logical comb filter;

Figures 7A and 7B are views depicting how signal processing is carried out by the filter of Figure 6;

Figure 8A illustrates a phenomenon that occurs at a vertical edge of the $f_{sc}$ component of the luminance signal in the filter of Figure 6;

Figures 8B-1 to 8B-4 illustrate what happens at vertical edges of the $f_{sc}$ component of the luminance signal in the filter of Figure 6; and

Figure 8C illustrates what causes the phenomena at vertical edges of the $f_{sc}$ component of the luminance signal in the filter of Figure 6.

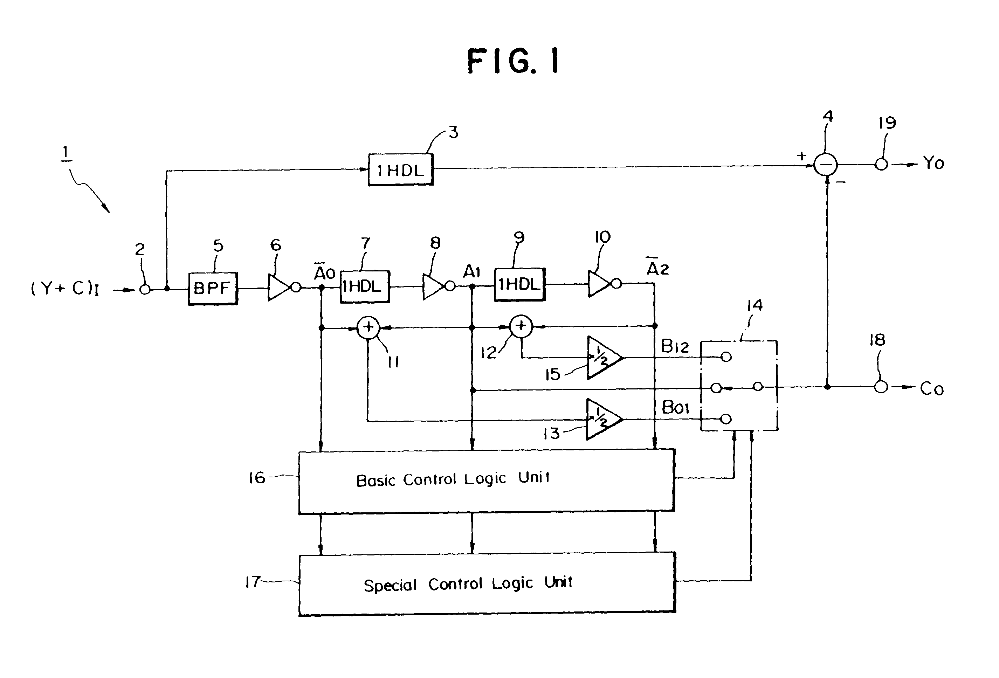

In the embodiment of logical comb filters shown in Figure 1, a signal $(Y + C)_l$ is supplied to an input terminal 2. The input signal $(Y + C)_l$ branches into two components, one being supplied to a subtracter 4 via a 1H delay line 3 and the other to a band-pass filter 5.

The band-pass filter 5 is designed to let pass the signal component with its centre at $f_{sc}$. The output of the band-pass filter 5 is supplied to a 1H delay line 7 via a NOT circuit 6. In turn, the 1H delay line 7 supplies a signal delayed by 1H relative to the input signal $\overline{A}_0$ to a downstream 1H delay line 9 via a NOT circuit 8.

The 1H delay line 9 supplies a NOT circuit 10 with a signal delayed by another 1H relative to the input signal $A_1$. This provides a signal $\overline{A}_2$.

An adder 11 admits the signal $\overline{A}_0$ from the NOT circuit 6 and the signal $A_1$ from the NOT circuit 8. The output of the adder 11 is supplied to a multiplier 13 having a coefficient of 1/2. The output signal $B_{01}$ of the multiplier 13, which has a level $(V_0 + V_1)/2$ , is supplied to a changeover switch 14.

Another adder 12 admits the signal $A_1$ from the NOT circuit 8 and the signal $\overline{A}_2$ from the NOT circuit 10. The output of the adder 12 is supplied to a multiplier 15 having a coefficient of 1/2. The output signal $B_{12}$ of the multiplier 15, which has a level $(V_1 + V_2)/2$ , is supplied to the changeover switch 14.

Besides admitting the signals $B_{01}$ and $B_{12}$, the changeover switch 14 also receives the signal $A_1$ from the NOT circuit 8. In accordance with a signal received from a control logic unit to be described later, the changeover switch 14 selects one of the signals $B_{01}$, $B_{12}$ and $A_1$ for output.

The control logic unit comprises a basic control logic unit 16 and a special control logic unit 17. The basic control logic unit 16 makes decisions on the processing according to the algorithms (1) and (2) described earlier. The special control logic unit 17 makes decisions on the processing in accordance with the algorithm (3). Each control logic unit receives three line signals $\overline{A}_0$, $A_1$ and $\overline{A}_2$. The result of a decision by each control logic unit is sent as a changeover signal to the changeover switch 14.

The signal selected by the changeover switch 14 is supplied to a signal output terminal 18 and to the subtracter 4. This causes an output signal $C_0$ to appear at the signal output terminal 18. The subtracter 4 subtracts the signal $C_0$ from the composite video signal delayed by 1H by the 1H delay line 3, thus generating an output signal $Y_0$ that appears at a signal output terminal 19.

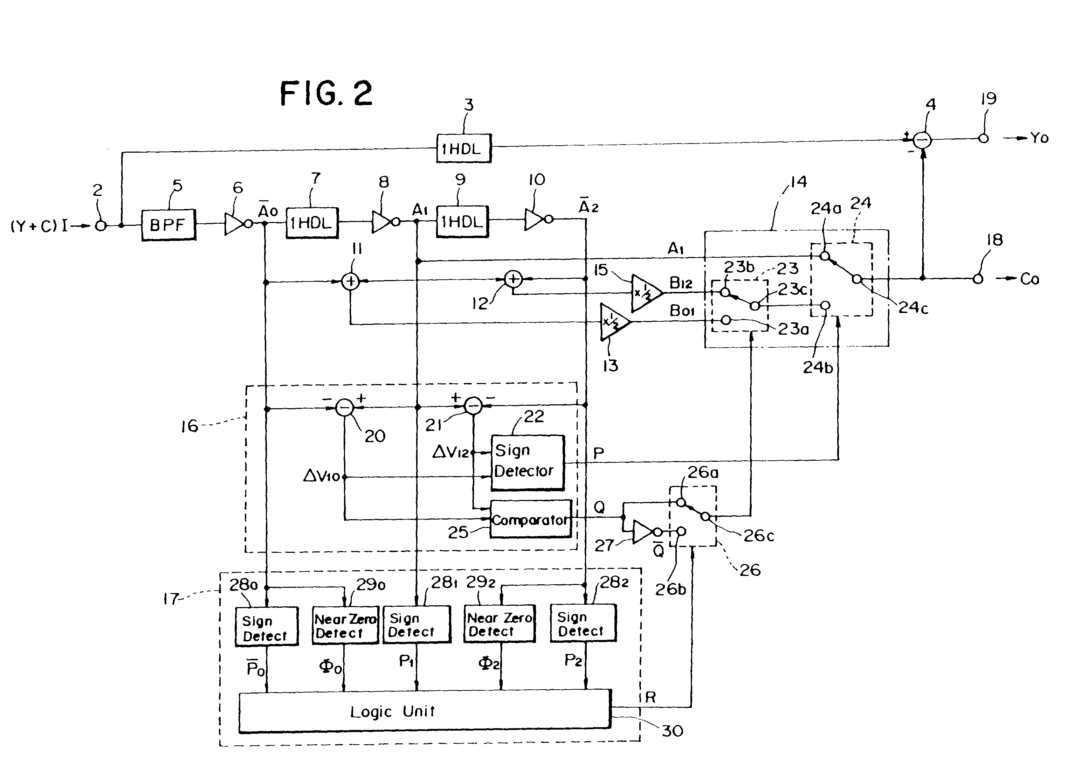

Below is a description of how the major parts of the embodiment, centring on the basic control logic unit 16, operate, reference being made to Figure 2.

One subtracter 20 receives the signals $A_1$ and $\overline{A}_0$, and another subtracter 21 receives the signals $A_1$ and $\overline{A}_2$. Differential signals generated by the two subtracters 20 and 21 are supplied to a sign detector 22.

The sign detector 22 checks to see if the signal level $V_1$ falls between levels $V_0$ and $V_2$ based on the differential signals from the subtracters 20 and 21 being positive or negative. The result of the decision is generated by the sign detector 22 in the form of a signal P.

A case may be assumed in which $\Delta V_{10} = V_1 - V_0$ and $\Delta V_{12} = V_1 - V_2$ . In that case, if the sign of the level $\Delta V_{10}$ of the differential signal from the subtracter 20 does not coincide with the sign of the level $\Delta V_{12}$ of the differential signal from the subtracter 21, then either $V_0 < V_1 < V_2$ or $V_2 < V_1 < V_0$. According to the algorithm (1) the signal $A_1$ is adopted. If the signal of $\Delta V_{10}$ matches that of $\Delta V_{12}$, the processing is carried out in accordance with the algorithm (2) or (3).

What has been described so far is summarized in the following table:

Table 1

| $\Delta V_{10}$ \ $\Delta V_{12}$ | ⊕ | ⊖ |
|---|---|---|
| ⊕ | (2) or (3) | (1) |
| ⊖ | (1) | (2) or (3) |

In the table, the symbol ⊕ indicates that the signal level differential is positive; the symbol ⊖ indicates that the signal level differential is negative. Numbers (1), (2) and (3) designate the numbers of algorithms to be followed.

The output signal P from the sign detector 22 has the logic level corresponding to the decision made as above. For example, if the algorithm (1) is to be followed, the signal P comprises a "1"; if the algorithm (2) or (3) is to be followed, the signal P comprises a "0". This signal P is supplied to the changeover switch 14.

In Figure 2, two switching elements 23 and 24 are used to illustrate the switching action of the changeover switch 14, so that the operation may be better understood.

The switching element 23 has two input terminals 23a and 23b. The terminal 23a receives the signal $B_{01}$ from the multiplier 13, and the terminal 23b receives the signal $B_{12}$ from the multiplier 15.

The switching element 24 also has two input terminals 24a and 24b. The terminal 24a receives the signal $A_1$ from the NOT circuit 8. The terminal 24b receives the signal ($B_{01}$ or $B_{12}$) selected by the switching element 23 via an output terminal 23c.

The action of the switching element 24 is controlled by the signal P from the sign detector 22. That is, when the signal P is "1", the contact is made at 24a. This allows the signal $A_1$ to be selected according to the algorithm (2). When the signal P is "0", the contact is made at 24b. This causes the signal $B_{01}$ or $B_{12}$ to be selected according to the algorithm (2) or (3).

A comparator 25 is provided to judge whether the signal level $V_1$ is closer to (or further from) $V_0$ than to $V_2$ or vice versa. The comparator 25 receives the differential signals from the subtracters 20 and 21 and generates a signal (called signal Q) in accordance with the level $\Delta V_{10}$ being higher than the level $\Delta V_{12}$ or vice versa. Illustratively, the logic level of the signal Q is "1" when $|\Delta V_{10}| > |\Delta V_{12}|$, and "0" when $|\Delta V_{10}| < |\Delta V_{12}|$.

A switching element 26 has two input terminals 26a and 26b. The terminal 26a receives the signal Q. The terminal 26b receives a signal $\bar{Q}$ via a NOT circuit 27. The switching element 26 is operated according to the signal from the special control logic unit 17.

The signal Q or $\bar{Q}$ obtained from the output terminal 26c of the switching element 26 is used as the changeover signal for the switching element 23. That is, when the logic level of the signal Q or $\bar{Q}$ is "1", the signal $B_{12}$ is selected; when the logic level of the signal Q or $\bar{Q}$ is "0", the signal $B_{01}$ is selected.

To recapitulate, the basic control block described above operates as follows.

With respect to the algorithm (1), the sign detector 22 judges that the signal level $V_1$ is between $V_0$ and $V_1$. This causes the signal P to be supplied to the changeover switch 14, thereby allowing the signal $A_1$ to be selected.

For example, in the case of Figure 7A (where $V_0 < V_1 < V_2$), the sign detector 22 judges that $\Delta V_{10} > 0$ and that $\Delta V_{12} < 0$. Because the two signs do not coincide with each other, the signal P is set to "1". This causes the contact of the switching element 24 to be made at 24a, allowing the signal $A_1$ to be output as the signal $C_0$.

With respect to the algorithm (2), the sign detector 22 judges that the signal level $V_1$ does not fall between $V_0$ and $V_2$. Thus the signal P is set to "0". This causes the contact of the switching element 24 to be made at 24b.

The comparator 25 judges that either the signal level $V_0$ or $V_2$ is the closes to $V_1$. As a result, the signal Q is supplied to the switching element 23 via the switching element 26. This causes either the signal $B_{01}$ or $B_{12}$ to be selected.

For example, in the case of Figure 7B (where $V_1 > V_2 > V_0$), the sign detector 22 judges that $\Delta V_{10} > 0$ and that $\Delta V_{12} > 0$. Because the two signs coincide with each other, the signal P is set to "1". This causes the contact of the switching element 24 to be made at 24b. The comparator 25 judges that $V_2$ is closer to $V_1$, since $|\Delta V_{10}| > |\Delta V_{12}|$. This sets the signal Q to "1". In that case, the contact of the switching element 26 is considered to be made at 26a by the changeover signal from the special control logic unit, as will be described later. This causes the signal Q to be sent unchanged to the switching element 23. The contact of the switching element 23 is made at 23a, and the signal $B_{12}$ is selected.

The processing described above is summarised in the following table:

Table 2

| $\Delta V_{10}$ | $\Delta V_{12}$ | $\|\Delta V_{10}\|-\|\Delta V_{12}\|$ | P | Q | $S_{23}$ | $S_{24}$ |
|---|---|---|---|---|---|---|
| $\oplus$ | $\oplus$ | $\oplus$ | 0 | 1 | $B_{12}$ | $B_{12}$ |
| $\oplus$ | $\oplus$ | $\ominus$ | 0 | 0 | $B_{01}$ | $B_{01}$ |
| $\oplus$ | $\ominus$ | - | 1 | - | - | $A_1$ |
| $\ominus$ | $\oplus$ | - | 1 | - | - | $A_1$ |
| $\ominus$ | $\ominus$ | $\oplus$ | 0 | 1 | $B_{12}$ | $B_{12}$ |
| $\ominus$ | $\ominus$ | $\ominus$ | 0 | 0 | $B_{01}$ | $B_{01}$ |

In the table above, the symbols $\oplus$ and $\ominus$ have the same meaning as described in connection with Table 1. Symbol $S_{23}$ designates the signal to be selected by the switching element 23; $S_{24}$ denotes the signal to be selected by the switching element 24 (that is, signal $C_0$); and "-" indicates that the corresponding value is unpredictable.

Prior to a description of the special control logic unit 17, there will be described specific relationships between the three line signals, the relationships being judged to justify the application of the algorithm (3) as special cases.

As described earlier, the irregularities in connection with the $f_{sc}$ component of the Y signal result from the uniform judgement that the $f_{sc}$ component of the input signal is always the chrominance signal.

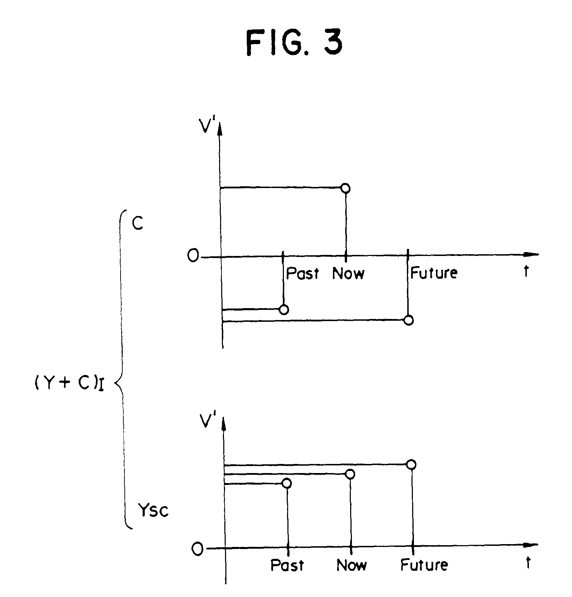

Figure 3 illustrates the output signal levels (represented by V') of the band-pass filter 5 where three line signals under the NTSC standard have a high degree of vertical correlation with one another. In Figure 3, reference character S stands for the C signal, $Y_{sc}$ for the $f_{sc}$ component of the Y signal, t for the time, and a hollow circle for the levels of the three line signals 1H apart from one another.

The C signal has its phase inverted for every scanning line because of the effect of the frequency interleaving involved. So when the degree of vertical correlation between the three line signals is high, the phase of the C signal is inverted on every horizontal scanning line, whereas the Y signal is supposed to keep its phase unchanged.

That it, it is necessary to distinguish the C signal from the Y signal in terms of the $f_{sc}$ component. Prior attempts to carry out the processing uniformly using the algorithm (2) alone have resulted in the irregularities mentioned above.

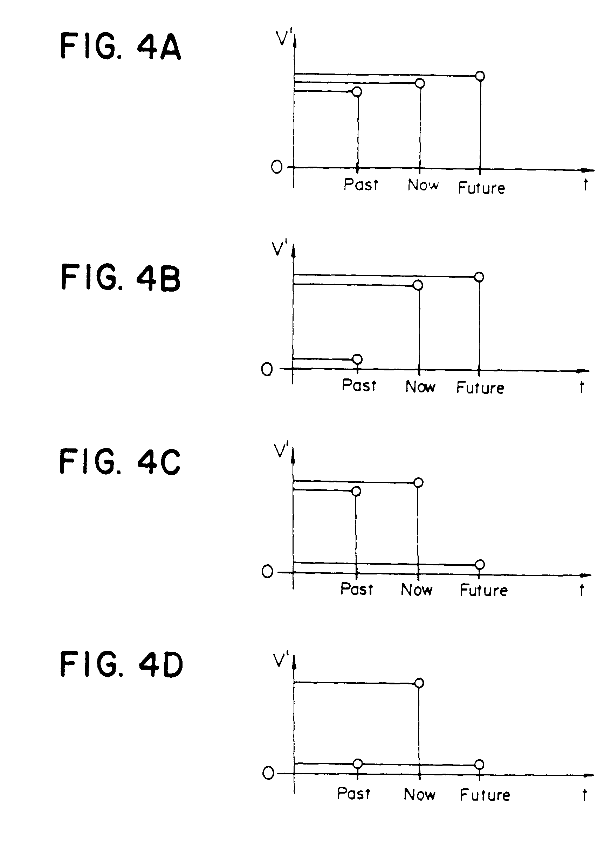

One solution to the problem above is implemented by applying the algorithm (3) to the illustrative cases in Figure 4 (where correlations between signal levels are those immediately downstream of the band-pass filter 5). In the case of Figure 4A, the three line signals are in phase with one another and have a non-zero value each. In the cases of Figures 4B and 4C, a 1H delay signal corresponding to a vertical edge exists. In the case of Figure 4D, the signal levels around 1H are close to zero with respect to a non-zero 1H delay signal. In such cases, none of the signals involved is regarded as the C signal. Instead, the algorithm (3) mentioned above is applied.

The special control logic unit 17 is provided to detect the cases depicted in Figures 4A to 4D so as to select the mean level between the signal level $V_1$ and the level $V_0$ or $V_2$, whichever is closer to $V_1$.

In Figure 2, a sign detector $28_0$ (i = 0, 1, 2) is provided to determine whether the input signal level is positive or negative, and a near-zero detector $29_0$ (i = 0, 2) provided to determine whether or not the signal level is near zero.

In operation, the sign detector $28_0$ detects whether the signal level $V_0$ of the signal $\overline{A}_0$ is positive or negative. A signal ($\overline{P}_0$) reflecting the result of the decision is sent to a logic operation unit 30. The near-zero detector $29_0$ detects whether or not the level $V_0$ is near zero. Another signal ($\Phi_0$) reflecting the result of the latter decision is also sent to the logic operation unit 30.

Regarding the signal $A_1$, only a sign detector $28_1$ is provided. The output signal $P_1$ of the sign detector $28_1$ is supplied to the logic operation unit 30.

Regarding the signal $\overline{A}_2$, as with the signal $\overline{A}_0$, both a sign detector $28_2$ and a near-zero detector $29_2$ are provided. The output signal $P_2$ of the sign detector $28_2$, and the output signal of the near-zero detector $29_2$ are sent to the logic operation unit 30.

The bars over the reference characters $P_0$ and $P_2$ means that each corresponding signal is inverted. The three line signals shown in Figure 4 indicate the signal levels immediately downstream of the band-pass filter 5. Since sign detection is carried out in this example using the phase-inverted signals $\overline{A}_0$ and $\overline{A}_2$, it is necessary to interpret inversely the results of the sign detection regarding the signals $\overline{A}_0$ and $\overline{A}_2$.

That is, the logic level of the signal $P_1$ is set to "1" when the sign of $V_1$ is positive, and is set to "0" when the sign of $V_1$ is negative. Conversely, the logic level of the signal $\overline{P}_0$ or $\overline{P}_2$ is set to "0" when the sign of $V_0$ or $V_2$ is positive, and is set to "1" when the sign of $V_0$ or $V_2$ is negative.

The logic level of the signal $\Phi_0$ or $\Phi_2$ is set to "1" in case of a near-zero value; otherwise the logic level is set to "0".

The logic operation unit 30 makes decisions on the levels of the three line signals as depicted in Figure 4 using such signals as the $\overline{P}_0$, $P_1$ and $\overline{P}_2$ from the sign detector $28_i$ (i = 0, 1, 2) as well as the signal $\Phi_i$ (i = 0, 2) from the near-zero detector $29_i$ (i = 0, 2).

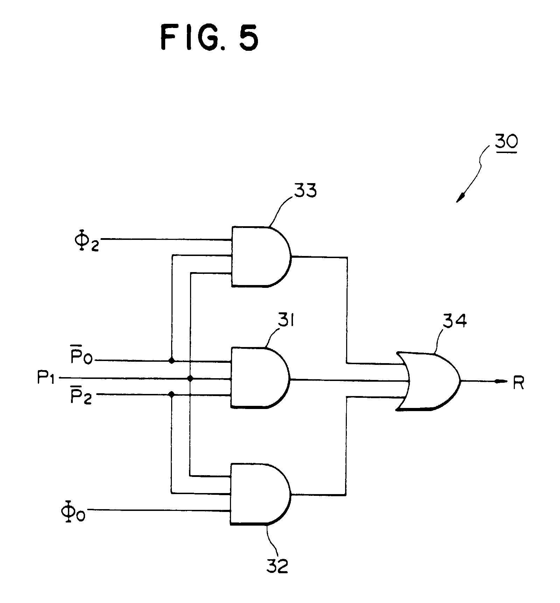

Figure 5 equivalently illustrates the processing performed by the logic operation unit 30 using logic circuits. In Figure 5, the output signals $\overline{P}_0$, $P_1$ and $\overline{P}_2$ of the sign detector $28_i$ are input to an AND circuit 31. When the output signal of the AND circuit 31 is High, that means the signs of all three line signals before phase inversion coincide with one another, as in the case of Figure 4A.

The signals of $P_1$, $\overline{P}_2$ and $\Phi_0$ are input to a three-input AND circuit 32. If the output of the AND circuit 32 is High, that means the signal level correlation shown in Figure 4B is detected.

The signals $\overline{P}_0$, $P_1$ and $\Phi_2$ are input to a three-input AND circuit 33. If the output signal of the AND circuit 33 is High, that means the signal level correlation in the case of Figure 4C is detected.

If the output signal level of the AND circuit 32 and that of the AND circuit 33 are High, that means the signal level correlation found in Figure 4D is detected.

These AND outputs are supplied to a three-input OR circuit 34. The output signal of the OR circuit 34 is supplied as the changeover signal to the switching element 26.

The logic level of the signal R is set to "1" when the cases of Figures 4A to 4D are detected by the logic operation unit 30, and is otherwise set to "0". That is, when the logic level of the signal R is "1", the contact of the switching element 26 is made at 26b. This causes the signal $\overline{Q}$ to be selected via the NOT circuit 27. When the logic level of the signal R is "0", the contact of the switching element 26 is made at 26a. This causes the signal Q to be selected.

The signal R is set to "1" when the special control logic unit 17 detects any of the cases of Figures 4A to 4D regarding the signal level correlation of the three line signals. This causes the switching element to select the signal $\overline{Q}$.

In this manner, the switching element 23 is supplied with the changeover signal $\overline{Q}$ reflecting the opposite of the role that the signal Q is to play in the basic control logic unit 16, the role being to find the mean level between $V_1$ and the level closest thereto.

That is, the signal Q is used to obtain the mean level between $V_1$ and the signal level farthest therefrom. When the signal R is set to "0", the signal Q is selected by the switching element 26.

The processing described above is summarized in the following table.

Table 3

| $\overline{P_0}$ | $P_1$ | $\overline{P_2}$ | $\Phi_0$ | $\Phi_2$ | R | $S_{26}$ |
|---|---|---|---|---|---|---|
| 1 | 1 | 1 | 0 | 0 | 1 | $\overline{Q}$ |
| 1 | 1 | - | - | 1 | 1 | $\overline{Q}$ |
| - | 1 | 1 | 1 | - | 1 | $\overline{Q}$ |
| 1 | 1 | 0 | - | 0 | 0 | Q |
| 0 | 1 | 1 | 0 | - | 0 | Q |
| 1 | 0 | 0 | - | - | 0 | Q |
| 0 | 1 | 0 | - | - | 0 | Q |
| 0 | 0 | 1 | - | - | 0 | Q |

In Table 3, symbol S26 designates the signal to be selected by the switching element 26, and symbol "-" indicates that the corresponding value is unpredictable.

In the logical comb filter 1 described above, two groups of circuits are distinctly separated from each other. One group of circuits intended to generate the signals ($A_1$, $B_{01}$, $B_{12}$) to be selected by the changeover switch 14 comprises the band-pass filter 5, the delay lines 7 and 9, the NOT circuits 6, 8 and 10, the adders 11 and 12, and the multipliers 13 and 15. The other group of circuits intended to make decisions on signal selection comprises the basic control logic unit 16 and special control logic unit 17. This means that the new algorithm (3) is readily added to the algorithms (1) and (2) in the basic control logic unit 16.

The reason for the ease of making the addition above is that the special control logic unit 17 comprises circuits intended only to make logical decisions on special cases of signal level correlation between the three line signals, those cases requiring special processing. All that is needed here is suitably to control the switching action of the changeover switch 15 in accordance with the result of each decision.

As described above, there is provided the logical comb filter for video signals comprising the first delay line, the second delay line connected to the first delay line, the second delay line connected to the first delay line serially, the first mean level calculator connecting its input terminals to the input and output terminals of the first delay line, the second mean level calculator connecting its input terminals to the input and output terminals of the second delay line, the changeover means connecting its input terminals to the output of the first delay line and the output terminals of the first and second mean level calculators, and the control logic unit connecting its input terminals to the input and output terminals of the first and second delay lines.

The logical comb filter thus embodied according to the invention comprises the logical decision section for selecting signals and the signal generating section for generating signals to be selected by the logical decision section. The signals to be selected are determined in advance; all that the logical decision section does is to select one of these signals. This means that the circuit configuration is made simpler and that it is easy to modify the circuitry involved.

The logical comb filter described above is only one preferred embodiment of the present invention. In the above description, Figures 4A to 4D illustrate typical cases to which the algorithm (3) is applied. Alternatives to such arrangements include one in which only the signs of signal levels are inverted for the necessary processing.

## Claims

1. A logical comb filter (1) for video signals, the filter (1) comprising:

   a first delay line (7);

a second delay line (9) connected to said first delay line serially;
a first mean level calculator (11, 13) connected to an input and an output terminal of said first delay line (7);
a second mean level calculator (12, 15) connected to an input and an output terminal of said second delay line (9);
a changeover means (14) connected to the output terminals of said first and second mean level calculators (11, 13; 12, 15) and controlled by a changeover signal; and
a control logic unit (16, 17) connected to the input and output terminals of said first and second delay lines (7, 9) and outputting said changeover signal;

characterised in that:

the changeover means (14) is also connected to an output of said first delay line (7); and
said control logic unit (16, 17) includes:
sign detectors ($28_0$, $28_1$, $28_2$) connected to the input and output terminals of said delay lines (7, 9); and
near-zero detectors ($29_0$, $29_2$) connected to said delay lines (7, 9).

**2.** A filter (1) according to claim 1 further comprising a band-pass filter (5) for passing a chrominance signal of an input video signal.

**3.** A filter (1) according to any one of the preceding claims wherein said changeover means (14) comprises a plurality of two-contact switches (23, 24).

**4.** A filter (1) according to any one of the preceding claims wherein said control logic unit (16, 17) comprises digital logic circuits (31 to 34).

**5.** A filter (1) according to claim 4 wherein said digital logic circuits (16, 17) are a plurality of AND gates (31 to 33) and an OR gate (34).

**Patentansprüche**

**1.** Logikkammfilter (1) für Videosignale, wobei das Filter (1) umfaßt:

eine erste Verzögerungsleitung (7);
eine zweite Verzögerungsleitung (9), die in Reihe mit der ersten Verzögerungsleitung verbunden ist;
einen ersten Mittelwert-Pegelrechner (11, 13), der mit einem Eingangs- und Ausgangsanschluß der ersten Verzögerungsleitung (7) verbunden ist;
einen zweiten Mittelwert-Pegelrechner (12, 15), der mit einem Eingangs- und Ausgangsanschluß der zweiten Verzögerungsleitung (9) verbunden ist;
eine Umschalteinrichtung (14), die mit dem Ausgangsanschlüssen des ersten und zweiten Mittelwert-Pegelrechners (11, 13; 12, 15) verbunden ist und die durch ein Umschaltsignal gesteuert wird; und
eine Steuerlogikeinheit (16, 17), die mit den Eingangs- und Ausgangsanschlüssen der ersten und zweiten Verzögerungsleitung (7, 9) verbunden ist und das Umschaltsignal ausgibt;

**dadurch gekennzeichnet, daß**

die Umschalteinrichtung (14) auch mit einem Ausgangsanschluß der ersten Verzögerungsleitung (7) verbunden ist; und
die Steuerlogikeinheit (16, 17) aufweist:
Vorzeichen-Detektoren ($28_0$, $28_1$, $28_2$), die mit den Eingangs- und Ausgangsanschlüssen der Verzögerungsleitungen (7, 9) verbunden sind, und
Nahe-Null-Detektoren ($29_0$, $29_2$), die mit denverzögerungsleitungen (7, 9) verbunden sind.

**2.** Filter (1) nach Anspruch, welches außerdem ein Bandpaßfilter (5) umfaßt, welches ein Chrominanzsignal eines Eingangsvideosignals durchläßt.

**3.** Filter (1) nach einem der vorhergehenden Ansprüche, wobei die Umschalteinrichtung (14) mehrere zweipolige Schalter (23, 34) umfaßt.

**4.** Filter (1) nach einem der vorhergehenden Ansprüche, wobei die Steuerlogikeinheit (16, 17) digitale Logikschaltungen (31 bis 34) umfaßt.

**5.** Filter (1) nach Anspruch 4, wobei die digitalen Logikschaltungen (31 bis 34) mehrere UND-Gates (31 bis 33) und ein ODER-Gate (34) sind.

**Revendications**

**1.** Filtre logique en peigne pour des signaux vidéo, le filtre (1) comprenant :

une première ligne à retard (7) ;
une seconde ligne à retard (9) montée en série avec ladite première ligne à retard ;
un premier calculateur de niveau moyen (11, 13) raccordé à une borne d'entrée et à une borne de sortie de ladite première ligne à retard (7) ;
un second calculateur de niveau moyen (12, 15) raccordé à une borne d'entrée et à une borne de sortie de ladite seconde ligne à retard (9) ;
un dispositif inverseur (14) raccordé aux bornes de sortie desdits premier et second calculateurs de niveau moyen (11, 13 ; 12, 15) et commandé par un signal inverseur ; et
une unité de commande logique (16, 17) raccordée aux bornes d'entrée et de sortie desdites première et seconde lignes à retard (7, 9) ; et fournissant ledit signal inverseur ;

caractérisé en ce que :

le dispositif inverseur (14) est aussi raccordé à une sortie de ladite première ligne à retard (7) ; et
ladite unité logique de commande (16, 17) comprend :
des détecteurs de signe ($28_0$, $28_1$, $28_2$) raccordés aux bornes d'entrée et de sortie desdites lignes à retard (7, 9) ; et
des détecteurs proche de zéro ($29_0$, $29_2$) raccordés auxdites lignes à retard (7, 9).

**2.** Filtre (1) selon la revendication 1, comprenant en outre un filtre passe-bande (5) pour passer un signal de chrominance d'un signal vidéo d'entrée.

**3.** Filtre (1) selon l'une quelconque des revendications précédentes dans lequel le dispositif inverseur (14) comprend une pluralité de commutateurs à deux contacts (23, 24).

**4.** Filtre (1) selon l'une quelconque des revendications précédentes dans lequel ladite unité logique de commande (16, 17) comprend des circuits logiques numériques (31 à 34).

**5.** Filtre (1) selon la revendication 4, dans lequel lesdits circuits numériques logiques (16, 17) sont une pluralité de portes ET (31 à 33) et une porte OU (34).

# FIG. I

EP 0 639 891 B1

# FIG. 2

EP 0 639 891 B1

# FIG. 3

FIG. 4A

FIG. 4B

FIG. 4C

FIG. 4D

# FIG. 5

# FIG. 6

# FIG. 7A

# FIG. 7B

FIG. 8A

FIG. 8B-1

| n | H | L | H | L | H |
|---|---|---|---|---|---|
| n+1 | | | | | |
| n+2 | H | | | | |

↓ BPF

FIG. 8B-2

| n | H | L | H | L | H |
|---|---|---|---|---|---|
| n+1 | | | | | |
| n+2 | $\phi$ | | | | |

x

↓ Phase reverse

FIG. 8B-3

| n | L | H | L | H | L |
|---|---|---|---|---|---|
| n+1 | H | L | H | L | H |
| n+2 | $\phi$ | | | | |

↓ Averaging

FIG. 8B-4

| n | L | H | L | H | L |
|---|---|---|---|---|---|
| n+1 | H/2 | L/2 | H/2 | L/2 | H/2 |
| n+2 | $\phi$ | | | | |

# FIG. 8C